(19) Europäisches Patentamt
European Patent Office
Office européen des brevets

(11) Publication number: **0 084 844**
**B1**

# (12) EUROPEAN PATENT SPECIFICATION

(45) Date of publication of patent specification: **16.07.86**

(51) Int. Cl.[4]: **H 03 K 3/356**

(21) Application number: **83100399.1**

(22) Date of filing: **18.01.83**

## (54) FET circuits.

(30) Priority: **20.01.82 JP 8119/82**
**16.02.82 JP 23802/82**
**16.02.82 JP 23803/82**
**11.05.82 JP 79349/82**

(43) Date of publication of application:
**03.08.83 Bulletin 83/31**

(45) Publication of the grant of the patent:
**16.07.86 Bulletin 86/29**

(84) Designated Contracting States:
**DE FR GB**

(56) References cited:
**FR-A-2 115 259**
**GB-A-2 081 041**
**US-A-4 253 163**

**IBM TECHNICAL DISCLOSURE BULLETIN, vol. 17, no. 9, February 1975, pages 2582-2583, New York, USA J.L. CHU et al.: "Low-power, high-speed sense latch"**

**IBM TECHNICAL DISCLOSURE BULLETIN, vol. 14, no. 1, June 1971, page 208, New York, USA D.W. KEMERER: "Fet-emitter follower cell"**

**ELECTRONIC, vol. 52, no. 9, April 1979, pages 125-135, New York, USA P. CAPECE: "The race heats up in fast static RAMs"**

(73) Proprietor: **Matsushita Electric Industrial Co., Ltd.**
**1006, Oaza Kadoma**
**Kadoma-shi Osaka-fu, 571 (JP)**

(72) Inventor: **Katsu, Shin-ichi**
**Dai-2-Shokiso, 35-22 Gunge-shinmachi**
**Takatsuki City, 569 (JP)**
Inventor: **Nambu, Shutaro**
**2-12-205, Minamiai 2-chome**
**Ibaraki City, 567 (JP)**
Inventor: **Shimano, Akio**
**6-11, Higashinakajima, 4-chome**
**Higashiyodogawa-ku Osaka City 533 (JP)**

(74) Representative: **Patentanwälte Kirschner & Grosse**
**Herzog-Wilhelm-Strasse 17**
**D-8000 München 2 (DE)**

(56) References cited:
**TOUTE L'ELECTRONIQUE, no. 354, April 1971, pages 27-32, Paris, FRA R. DAMAYE: "les bascules bistables"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 084 844 B1

**Description**

The present invention relates to a FET circuit according to the prior art portion of claim 1.

The invention is especially applicable to circuits of metal semiconductor field effect transistors (herein after referred to a MESFET) which constitute a latch circuit. Such a FET circuit is disclosed e.g. in the publication "Threshold voltage margin of normally off GaAs MESFET in DCFL Circuit", Ino et al., IEEE Electron Device letters, Vol. EDL 2, No. 6, p. 144—145, 1981.

Fig. 1 shows a conventional latch comprising normally-off type MESFETs wherein the threshold voltage $V_T$ of the MESFETs is positive. As shown in Fig. 1, the conventional latch circuit has a pair of MESFETs $Q_{11}$ and $Q_{12}$ which are connected by their sources to a common grounding terminal 12, by their drains through respective resistors $R_{11}$ and $R_{12}$ to a positive power supply terminal 11, and by their gate electrodes to the drain electrode of the other MESFET $Q_{12}$ or $Q_{11}$, respectively. The output terminals 13 and 14 are connected to the drains of the MESFETs $Q_{11}$ and $Q_{12}$, respectively. In this latch circuit, in order that "H" level and "L" level are issued at the output terminals 13 and 14, respectively, or vice versa, it is necessary that one of the MESFET $Q_{11}$ or $Q_{12}$ becomes sufficiently on and the other one becomes off or approximately off. Provided that thereshold voltage of the MESFETs of $Q_{11}$ and $Q_{12}$ are $V_T$, and drain source current of on-state is $I_{ON}$, then for a state of MESFET $Q_{11}$ being on an "L" level voltage $V_L$ becomes

$$V_L = V_{DD} - I_{ON} \cdot R_{11} \quad (1)$$

At this time, the voltage $V_L$ is gate input voltage of the MESFET $Q_{12}$, and in order to change the MESFET $Q_{12}$ to off state the below mentioned relation is necessary:

$$V_L < V_T \quad (2)$$

In the similar manner, an "H" level voltage $V_H$ at the output terminal 14 is $V_{DD}$ at this time, or becomes $V_{DI}$ for a case where the power supply voltage $V_{DD}$ is higher than Schottky barrier voltage $V_{DI}$; ad in order to make the MESFET $Q_{11}$ on by the $V_H$ voltage at the output terminal 14 the next relation is necessary:

$$V_H > V_T \quad (3)$$

In this circuit if the threshold voltage $V_T$ decreases, the on current $I_{ON}$ increases, and therefore the "L" level voltage $V_L$ decreases. However, since the threshold voltage $V_T$ has decreased, the above-mentioned relation of inequity (2) holds only for very limited range of the threshold voltage $V_T$. When the threshold voltage $V_T$ increases, similarly the relation of the inequity (2) holds only for a small range of the threshold voltage $V_T$.

Detailed analysis of the above-mentioned relation has been made by circuit simulation by using computer and the simulated results are shown in a graph of FIG. 2, wherein curves $V_H$ and $V_L$ show "H" level voltage and "L" level voltage, respectively, and a line $V_C$ shows voltages of output terminals 13 and 14 when they become equal instead of being stabilized to "H" level or "L" level by the latching action, i.e. critical voltages to divide the "H" level and "L" level. And differences of this critical voltage and the "H" level or "L" level, namely $V_H - V_C$, $V_C - V_L$ are noise margins for latch stabilization.

From observation of the graph of Fig. 2 allowable range of the threshold voltage $V_T$ is about 0.1 to 0.2 volt. Accordingly, deviation $\Delta V_T$ of the threshold voltage $V_T$ is allowed only a range ±50mV. And this ±50mV deviation corresponds to very accurate controlling of ±40Å of 1000Å thick channel layer when the MESFET is made with GaAs substrate and carrier concentration of a channel layer is $10^{17}cm^{-3}$. And such very accurate controlling of the thickness is practically impossible when such logic circuits are manufactured with a high integration with a high manufacturing yield.

Fig. 3 shows another conventional example of latch using normally-on type MESFETs having negative threshold voltage in this Fig. 3. MESFETS $Q_{31}$ and $Q_{32}$ correspond to MESFETs $Q_{11}$ and $Q_{12}$ of Fig. 1 and resistors $R_{31}$ and $R_{32}$ correspond to resistors $R_{11}$ and $R_{12}$ of Fig. 1, respectively. And in this circuit of Fig. 3 there are two additional MESFETs $Q_{33}$ and $Q_{34}$ which are connected by their gates to the drains of the MESFETs $Q_{31}$ and $Q_{32}$, respectively, and by their sources through diodes $D_{31}$, $D_{32}$ and $D_{33}$ to the output terminal 33 and $D_{34}$, $D_{35}$ and $D_{36}$ to the output terminal 34, respectively, and by their drains commonly to a power supply terminal 31. This circuit has two negative power supply terminals, namely a first negative power supply terminal 32 corresponding to 12 of Fig. 1 and another negative power supply terminal 35 to which load resistors $R_{33}$ and $R_{34}$ of the source-follower MESFETs $Q_{33}$ and $Q_{34}$ are commonly connected. The diodes $D_{31}$ to $D_{33}$ and $D_{34}$ to $D_{36}$ are for leveling down source follower outputs so as to meet the input levels. Generally, normally-on type MESFET has an advantage of providing a larger on-current than normally-off type MESFET as shown in Fig. 4 and in the circuit of Fig. 3. By this large on-current, logic swing of the circuit is expanded thereby resulting in increasing of allowable range of deviation of the threshold voltage $\Delta V_T$ to be 0.5 to 1.0 V. However this conventional latch of Fig. 3 has a shortcoming of a large operating current and necessity of many diodes for level adjustments of outputs and further necessitates two power supplies. Therefore its power consumption is very large such that 10 to 100 times power consumption than the conventional normally-off type MESFET latch.

FET latch circuits comprising a pair of crosscoupled inverters, each inverter comprising a resistive load and an input-stage FET, the sources of the input stage FETs being connected to a common-connection point, are disclosed in the publication "IBM Technical Disclosure Bulletin" Vol. 14, No. 1, June 1971, page 208, and in the publication "Electronics", Vol. 52, No. 9, April 1979, pages 125 to 135.

A FET composite circuit with a R—S type flip-flop having output terminals, set and reset terminals, a clock input terminal and a reference input terminal is disclosed in GB—A—2,081,041. From the publication "Toute l'Electronique" No. 354, April 1971, pages 27 to 32, it is known to connect two R—S flip-flops together to form a master slave delay flip-flop. This master slave delay flip-flop has no reference inputs and, therefore, the reference input of one flip-flop is not connected to the clock input of the other flip-flop.

In view of the above-mentioned disadvantages, it is an object of the invention to provide a FET latch circuit having an extended allowable range of threshold voltage of the transistor which is effective for a stable operation without increasing the power consumption.

The solution of this object is especially defined in claim 1. Advantageous embodiments are defined in dependent claims.

The invention will be explained in the following by means of the drawings in which:

Fig. 1 is the circuit diagram of the conventional latch circuit using normally-off type MESFETs.

Fig. 2 is the graph showing the relation between threshold voltage of the MESFETs and operation of the circuit of Fig. 1.

Fig. 3 is the circuit diagram of the second conventional latch circuit using the normally-on type MESFETs.

Fig. 4 is the graph showing the current-voltage characteristics of the normally on-type MESFETs and normally-off type MESFETs.

Fig. 5 is a circuit diagram of a first embodiment of FET latch circuit embodying the present invention.

Fig. 6 is a graph showing a relation between threshold voltage and operation characteristic of the latch circuit of Fig. 5.

Fig. 7 is a circuit diagram of a second embodiment of FET latch circuit embodying the present invention.

Fig. 8 is a circuit diagram of a clocked reset-set flip-flop embodying the present invention.

Fig. 9 is a block diagram of a clocked master-slave delay flip-flop embodying the present invention.

Fig. 10 is a circuit diagram of an example of a static RAM embodying the present invention.

Fig. 11(a) is a circuit diagram of a part of modification of the examples of the present invention.

Fig. 11(b) is a circuit diagram of a part of modification of the examples of the present invention.

Fig. 12 is a circuit diagram of a part of modification of the examples of the present invention.

Description of the preferred embodiments

The present invention is elucidated in detail referring to Fig. 5 and thereafter.

Fig. 5 shows a first example of a latch embodying the present invention. As shown in Fig. 5 the latch comprises a pair of inverters $Q_{51}+Q_{53}$ and $Q_{52}+Q_{54}$. Each of the inverters comprises input stage FET $Q_{51}$ or $Q_{52}$ and a source follower FET $Q_{53}$ or $Q_{54}$. Each input stage FET is connected by its gate electrode to the source of the source follower FET $Q_{54}$ or $Q_{53}$ of the other inverter through a diode $D_{52}$ or $D_{51}$. Each source follower FET $Q_{54}$, $Q_{53}$ is connected by its gate to the drain of the input stage FET $Q_{52}$ or $Q_{51}$ and through a resistor $R_{52}$ or $R_{51}$ to a positive side power supply terminal 51. The sources of the input stage FET $Q_{51}$ and $Q_{52}$ are connected in common to a common connected point C and further a resistor $R_{55}$ as current source means is connected between common connected point C and the negative side power supply or ground terminal 52. Output terminals 53 and 54 are connected to junction points between the diode 51 and the gate electode of the FET $Q_{52}$ or to the junction point between the diode $D_{52}$ and the gate electrode of the FET 51, respectively, and the gate electrodes of the FET $Q_{51}$ and $Q_{52}$ are connected to the negative power supply terminal 52 through a resistor $R_{53}$ and $R_{54}$, respectively. The resistors $R_{51}$ and $R_{52}$are load resistors of the MESFETs $Q_{51}$ and $Q_{52}$, respectively, and resistors $R_{53}$ and $R_{54}$ are load resistors of the source follower MESFETs $Q_{54}$ and $Q_{53}$, respectively. The diodes $D_{51}$ and $D_{52}$ are for adjusting the input levels to the MESFETs $Q_{52}$ and $Q_{51}$, respectively. The output terminal 53 and 54 are of positive phase output and negative phase output, respectively.

Operation of latch of Fig. 5 is as follows.

When a MESFET $Q_{51}$ is on and MESFET $Q_{52}$ is off, then "L" level voltage $V_L$ is as follows:

$$V_L=V_{DD}-I_{ON}R_{51}-V_{GS}-V_D \tag{4}$$

Wherein

$I_{on}$ is an on-current flowing through the resistor $R_{51}$,

$V_{GS}$ is gate-source voltage of the MESFET $Q_{53}$,

$V_D$ is voltage drop across the diode $D_{51}$.

At the same time "H" level voltage $V_H$ is as follows:

$$V_H=V_{DD}-V_{GS}-V_D \tag{5}$$

Herein in order that the latch operates stably, to cut off the MESFET $Q_{52}$ by the "L" level voltage $V_L$ the following relation is necessary:

$$V_L<I_{ON}R_{55}+V_T \tag{6}$$

Now provided that threshold voltage of the MESFETs decrease, then on-current $I_{ON}$ of the MESFET $Q_{51}$ increases, and the "L" level voltage $V_L$ decreases. Accordingly, when the resistor $R_{55}$ is large, then the above-mentioned inequality (6) holds for a wide range of the threshold voltage $V_T$, and the latch performs a stable operation.

Experimental and computor simulated study shows that D.C. resistance of the current source means $R_{55}$ should be selected 5—50 times of each source-drain resistance of the on-MESFET $Q_{51}$ and $Q_{52}$, in order to perform good characteristics.

Fig. 6 is a graph showing allowable range of the threshold voltage $V_T$ of the MESFETs for performing normal performance as latch, simulated by computer. As shown by the curves the latch performs stable operation for a wide range of the threshold voltage $V_T$ between −0.6V and 0.3V. And furthermore when the resistor $R_{55}$ is sufficiently large, the critical voltage $V_C$ is always between the levels of "H" and "L", and accordingly the latch is very superior with respect to noise margin. Therefore in this circuit the deviations of the threshold voltage $\Delta V_T$ of the MESFETs are allowed to 0.9V, therefore difficulties of controlling of the threshold voltage in manufacturing process of the MESFETs is greatly eased. Furthermore with respect to the power consumption of the latch, very little power consumption, 1/2 to 1/10 times of the conventional latch using the normally-on type MESFETs suffices to operate the latch in accordance with the present invention, since the threshold voltage is around 0V hand hence on-current is very small, only one pair of level shifting diodes $D_{51}$ and $D_{52}$ of one stage suffices, and a negative power supply is unnecessary.

Fig. 7 shows a circuit diagram of a second example embodying the present invention. In this example in order to increase allowable threshold voltage ranges of the MESFETs plural stages of level shifting diodes $D_{51}$, $D_{53}$ and $D_{55}$ and $D_{52}$, $D_{54}$ and $D_{56}$ are used, and in order to increase logic swing of the MESFETs $Q_{51}$ and $Q_{52}$ by increasing the on-currents by selecting the threshold voltage $V_T$ of the MESFETs $Q_{51}$ and $Q_{52}$ deeper, a second negative power supply terminal 55 is provided and a pair of resistors $R_{53}$ and $R_{54}$ are connected respectively from the gate electrodes of the MESFET $Q_{51}$ and $Q_{52}$ to the common second negative power supply terminal 55. The level shifting diodes $D_{51}$ to $D_{56}$ should be selected to a desired number in order to meet desired input-output levels. The diode $D_{57}$ and $D_{58}$, which are connected between respective resistors $R_{51}$ and $R_{52}$ and the positive power supply terminal 51, are for increasing operation characteristic of the MESFETs $Q_{53}$ and $Q_{54}$ so as to operate in the current saturation region thereby increasing response of the source followers, and their number may be changed responding to the thereshold voltages of the MESFETs.

Other parts and components of the circuit which are corresponding to the circuit of Fig. 5 are designated by the same numerals as them, and the elucidations on them are omitted for simplicity of the explanation.

Fig. 8 shows a circuit diagram of a third example which is a clocked reset-set flip-flop using the latch of Fig. 5. In the circuit of Fig. 8 a MESFET $Q_{56}$ is connected by its drain to the common-connection point C, and by its gate to the reference input terminal 56. Another MESFET $Q_{55}$ is connected by its gate to a clock input terminal 55 and by its source commonly with the source of the MESFET $Q_{56}$ to the upper end of the current source means $R_{55}$. MESFETS $Q_{57}$ and $Q_{58}$ are common-connected with their sources to the drain of the MESFET $Q_{55}$. The gate of the MESFET $Q_{57}$ is connected to a reset input terminal 57. The gate of the MESFET $Q_{58}$ is connnected to a set input terminal 58, drains of the MESFETs $Q_{57}$ and $Q_{58}$ are connected to the drains of MESFET $Q_{51}$ and $Q_{52}$, respectively. The output terminals 53 and 54 are led out to a positive phase Q terminal 53 and negative phase $\bar{Q}$ terminal 54, respectively. The resistors $R_{51}$ and $R_{52}$ serve as common-resistors for common drain connected MESFETs $Q_{51}$, $Q_{57}$ and the common drain connected MESFETs $Q_{52}$, $Q_{58}$, respectively.

Other parts and components of the circuit which are corresponding to the circuit of Fig. 5 are designated by the same numerals as them, and the elucidations on them are omitted for simplicity of the explanation.

Operation of flip-flop of Fig. 8: when clock input terminal 55 is of higher potential than that of the reference voltage input terminal 56, then MESFETs $Q_{55}$ and $Q_{56}$ becomes on and off, respectively; and at that time when an "H" signal is added to either of the reset input terminal 57 or the set input terminal 58, then the MESFET $Q_{57}$ or $Q_{58}$ turns on, respectively. Then when the clock input terminal 55 is of lower potential than that of the reference voltage input terminal 56, the MESFET $Q_{55}$ or $Q_{56}$ turns off or on, respectively. At the same time, MESFETs $Q_{51}$, $Q_{52}$, $Q_{53}$ and $Q_{54}$ form a latch circuit, and therefore above-mentioned state which is designated by the state at the reset input terminal 57 and set input terminal 58 is retained as it is. And then this state is output from the output terminals 53 and 54.

This clocked reset-set flip-flop has such small power consumption as is substantially equal to that of the latch of Fig. 5, and allowable margin to the deviation of the threshold voltage of the latch is reflected to this flip-flop. That is, in the operation of increasing or decreasing the on-current due to deviation of the threshold voltage the voltage of the common-connected sources of the MESFETs $Q_{55}$ and $Q_{56}$ increases or decreases, but the allowable range of the threshold voltage of this flip-flop are equal to those of the latch since the potential of the reference input terminal 56 can be selected so as to certainly turn on or off the MESFETs $Q_{55}$ and $Q_{56}$.

As has been elucidated, the clocked reset-set flip-flop using the MESFET circuit in accordance with the present invention is operable at a very low power consumption and can stably operate for a wide range of threshold voltage.

Fig. 9 is a circuit diagram of a master-slave delay flip-flop of single phase clocked type which comprises the reset-set flip-flop shown in Fig. 8. In the circuit of Fig. 9 the reset-set flip-flops 91 and 92 are a master flip-flop and a slave flip-flop, respectively. And the set input terminal S, reset input terminal R, clock input terminal C, reference voltage input terminal REF, positive phase output terminal Q and negative phase output terminal $\bar{Q}$ correspond to the terminals 58, 57, 55, 56, 53 and 54, respectively. The first stage reset-set flip-flop 91 and the second stage reset-set flip-flop 92 are connected such that output terminals Q and $\bar{Q}$ of the former 91 are connected to the input terminals S and R of the latter 92, respectively, a clock input terminal C of the former 91 and a reference input terminal REF of the latter 92 are connected in common to a clock input terminal 93 of the composite circuit, a reference input terminal REF of the former 91 and a clock input terminal C of the latter 92 are connected in common to a first reference input terminal 94 of the composite circuit, a reset input terminal R of the former 91 is connected to a second reference input terminal 96, and a set input terminal S of the former 91 is connected to a set input terminal 95 of the composite circuit, and output terminals Q and $\bar{Q}$ of the latter 92 are connected to the output terminals 97 and 98 of the composite circuit, respectively.

Operation of the master-slave flip-flop of Fig. 9:

When potential of the clock input terminal 93 is higher than the potential of the first reference voltage input terminal 94, then in the master flip-flop 91 the input gates S and R opens and signals at the set input terminal is compared with the signal at the second reference voltage input terminal 96, and issues positive phase output and negative phase output from the output terminals Q and $\bar{Q}$ of the master flip-flop 91, respectively. On the other hand, in the slave flip-flop 92, the input gate S and R are shut off. Next when the clock input terminal 93 is of low potential than the first reference voltage input terminal 94, then in the master flip-flop 91 the input gates S and R are shut off, and instead the input gates S and R of the slave flip-flop 92 are open, and then the signal at the output terminals Q and $\bar{Q}$ of the master flip-flop 91 is led into the input terminals S and R of the slave flip-flop 92. Accordingly the slave flip-flop 92 issues positive phase output signal and negative phase output signal to the output terminals 97 and 98, respectively.

In the above composite master-slave flip-flop circuit, in each of the flip-flop 91 and 92 a pair of the clock input terminal C and the reference voltage input terminal REF as well as the pair of set input terminal S and the reset input terminal R forms each-other differential input relation, and in each pair both inputs are compared to determine the input logic. Accordingly, by fixing one signal of the pair in DC voltage relation, it is possible to operate the circuit with only single phase signal. As a result for the clock input, only a single phase clock suffices. And furthermore there is no need of adding inverter to the input terminals S and R of the master flip-flop 91, and only simply impressing an input signal to input terminals suffices. Accordingly in the present circuit a clocked master-slave delay flip-flop can be constituted only with two reset-set flip-flop and without using inverter, thereby decreasing of area of IC chip and power consumption is possible. Furthermore by using only a single phase clock signal the master-slave flip-flop can be synchronized without delay and accurate operation is possible even at a high speed operation.

In above-mentioned example, in place of the level shift diode $D_{51}$ and $D_{52}$ series connected multiple diodes may be used depending on the extent of the level to be shifted thereby operation for large pinch off voltage $V_p$ of MESFET can be possible.

As elucidated above, the master-slave flip-flop of a single phase clocked type can be realized with dispensing with the inverter hitherto necessitated and thereby size of IC as well as power consumption can be decreased.

Fig. 10 shows a static RAM constituted with the latch of Fig. 5.

In this static RAM, a pair of MESFETs $Q_{15}$ and $Q_{16}$ are connected by their sources to the output terminals 53 and 54 of the latch of Fig. 5, respectively, and the gates of the MESFETs $Q_{15}$ and $Q_{16}$ are commonly connected to a control terminal 15, and the drains of the MESFETS $Q_{15}$ and $Q_{16}$ are connected to write-in terminal 16 and 17, respectively.

Other parts and components of the circuit which are corresponding to the circuit of Fig. 5 are designated by the same numerals as them, and the elucidations on them are omitted for simplicity of the explanation.

Operation of static RAM of Fig. 10:

In order to write-in, a positive voltage is impressed on the control terminal 15, and data signal is impressed either to the write-in terminal 16 or 17, thereby forcedly latching the MESFETs $Q_{51}$ and $Q_{52}$. Reading from this static RAM is made by impressing the control signal to the control terminal 15 and from the voltage state "H" or "L" of the terminals 16 and 17 the latch state is read out.

This static RAM has very small power consumption and can perform stable operation for wide range of threshold voltage of MESFETs, since the power consumption and allowable range of the threshold voltage is substantially the same as that of the latch of Fig. 5.

The circuit configurations of Fig. 5, Fig. 7, Fig. 8 and Fig. 10 are not limited to the circuits shown thereof, but instead, their current source means $R_{55}$ can be replaced by active load, for instance of drain-source impedance of a FET as shown in Fig. 11(a). By utilizing such active loads, the area necessitated on Ic can be decreased. Furthermore, such active load has more superior constant current characteristic than the fixed resistors. Accordingly by use of the active loads, the allowable range of the threshold voltage of MESFETs can be increased.

Fig. 11(b) shows further improved example where as the current source means a dual gate FET connected with both of its gate to the source.

Since the dual gate FET has more superior constant current characteristic than single gate FET, the circuit Fig. 11(b) wherein the dual gate FET $Q_{111'}$ is connected with their dual gates to the source to serve as current source means $R_{55}$ can perform more superior characteristic than Fig. 11(a).

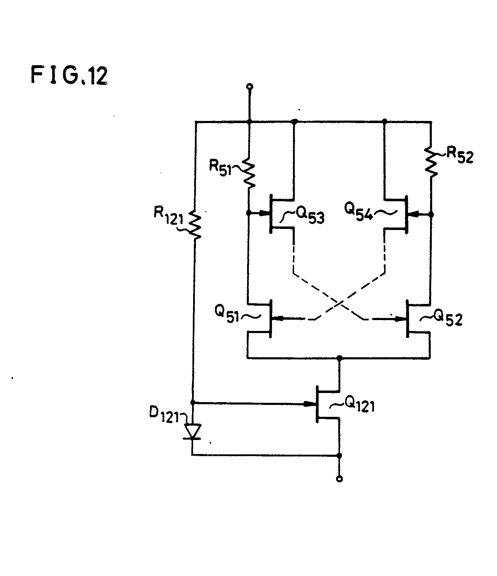

Fig. 12 shows further improved circuit of the present invention wherein as the current source means, source-and-drain circuit of a FET $Q_{121}$ is utilized and the gate of the FET $Q_{121}$ is connected to a junction point of a series connection of a resistor $R_{121}$ and diode $D_{121}$, which series connection is connected between the positive side power supply terminal 51 and the negative side power supply terminal 52. In the circuit of Fig. 12, the gate source circuit of the FET $Q_{121}$ is forward biased, and on-current flows through the FET $Q_{121}$. According to the circuit configuration of Fig. 12, for the FET $Q_{121}$ a normally-off type FET can be used. Accordingly there is no need of comprising normally-off type FETS and normally-on type FETs to constitute the latch, and accordingly manufacturing process becomes simple.

In the modified examples of Fig. 11(a), Fig. 11(b) and Fig. 12, other parts and components of the circuit which are corresponding to the circuit of Fig. 5 are designated by the same numerals as them or omitted from the drawing for simplicity, and the elucidations on them are omitted for simplicity of the explanation.

As has been elucidated with respect to many examples, the present invention is characterized by a latch circuit or its application with insertion of current source means between common-connection point C and the negative side power supply terminal 52.

It is naturally to be understood that, though in the examples a positive power supply voltage $V_{DD}$ is impressed to the terminal 51 and the negative side power supply terminal is grounded, of course it is possible that the terminal 51 is grounded and the terminal 52 is connected to a negative power supply voltage. That is, it is only necessary that the terminal 51 is connected to a higher voltage with respect to the terminal 52.

**Claims**

1. A FET circuit comprising a pair of inverters ($Q_{51}+Q_{53}$, $Q_{52}+Q_{54}$), each inverter comprising an input-stage FET ($Q_{51}$, $Q_{52}$), in which the input-stage FETs are connected by their sources to a common connection point (C) by their drains through respective resistors ($R_{51}$, $R_{52}$) to a first power supply terminal and by their gate electrodes to the output terminals (53, 54) of the respective other inverter ($Q_{52}+Q_{54}$, $Q_{51}+Q_{53}$), characterized in that a current source means ($R_{55}$) is connected between said common-connection point (C) and a second power supply terminal (52).

2. A FET circuit in accordance with claim 1, wherein said second power supply terminal (52) is grounding terminal.

3. A FET circuit in accordance with claim 1, wherein said current source means is a resistor ($R_{55}$).

4. A FET circuit in accordance with claim 1, wherein said current source means is a source-drain circuit of another FET ($Q_{111}$).

5. A FET circuit in accordance with claim 4, wherein the gate of said another FET ($Q_{111}$) is connected to its source.

6. A FET circuit in accordance with claim 5, wherein said current source means is a dual gate FET ($Q_{111'}$) with its two gates connected to its source.

7. A FET circuit in accordance with claim 1, wherein said FETs are Schottky junction gate FETs.

8. A FET circuit in accordance with claim 1, wherein each inverter comprises said input-stage FET ($Q_{51}$, $Q_{52}$) and another FET ($Q_{53}$, $Q_{54}$), which is connected by its gate to the drain of the corresponding input-stage FET ($Q_{51}$, $Q_{52}$), by its source through at least one respective diode ($D_{51}$, $D_{52}$) to a respective output terminal (53, 54) and by its drain to the first power supply terminal (51) and wherein the gate electrodes of said input-stage FETs ($Q_{51}$, $Q_{52}$) are connected through respective resistors ($R_{53}$, $R_{54}$) to another power supply terminal (55).

9. A FET circuit in accordance with claim 8, wherein said second and another power supply terminals (52, 55) are common.

10. A FET circuit in accordance with one of the claims 8 or 9, wherein the other FETs ($Q_{53}$, $Q_{54}$) are of the normally on type.

11. A FET circuit comprising a first reset-set flip-flop (91) and a second reset-set flip-flop (92), which form a composite circuit, in which said first reset-set flip-flop (91) and said second-flip-flop (92) are connected in a manner that output terminals Q and $\bar{Q}$ of the former (91) are connected to the input terminals S and R of the latter (92), respectively, a clock input terminal C of the former (91) and a reference input terminal REF of the latter (92) are connected in common to a clock input terminal (93) of said composite circuit, a reference input terminal REF of the former (91) and a clock input terminal C of the latter (92) are connected in common to a first reference input terminal (94) of said composite circuit, a reset input terminal R of the former (91) is connected to a second reference input terminal (96), a set input terminal S of the former (91) is connected to a delay input terminal (95) of the composite circuit, output terminals Q and $\bar{Q}$ of the latter (92) are connected to the output terminals (97 and 98) of the composite circuit, respectively, wherein each of said reset-set flip-flops (91, 92) comprises a FET circuit in accordance with claim 1.

**Patentansprüche**

1. Eine FET-Schaltung, enthaltend ein Paar von Invertern ($Q_{51}+Q_{53}$, $Q_{52}+Q_{54}$), wobei jeder Inverter einen Eingangsstufen - FET ($Q_{51}$, $Q_{52}$) aufweist, in welcher (Schaltung) die Eingangsstufen - FETs mit ihren Source-Anschlüssen an einen gemeninsamen Verbindungspunkt (D) mit ihren Drain - Anschlüssen durch entsprechende Widerstände ($R_{51}$, $R_{52}$) mit einem ersten Stromversorgungsanschluß und mit ihren Gate-Elektroden an die Ausgangsanschlüsse (53, 54) der jeweiligen anderen Inverter ($Q_{52}+Q_{54}$, $Q_{51}+Q_{53}$) angeschlossen sind, dadurch gekennzeichnet, daß eine Stromquelleneinrichtung ($R_{55}$) zwischem dem genannten gemeinsamen Verbindungspunkt (c) und einem zweiten Stromquellenanschluß (52) angeschlossen ist.

2. Eine FET-Schaltung nach Anspruch 1, bei der der genannte zweite Stromversorgungsanschluß (52) Erdanschluß ist.

3. Eine FET-Schaltung nach Anspruch 1, bei der die genannte Stromquelleneinrichtung ein Widerstand ($R_{55}$) ist.

4. Eine FET-Schaltung nach Anspruch 1, bei der die genannte Stromquelleneinrichtung eine Source-Drain-Strecke eines weiteren FET ($Q_{111}$) ist.

5. Eine FET-Schaltung nach Anspruch 4, bei der der Gate-Anschluß des genannten weiteren FETs ($Q_{111}$) mit seinem Sourse-Anschluß verbunden ist.

6. Eine FET-Schaltung nach Anspruch 5, bei der die genannte Stromquelleneinrichtung eine Doppel-Gate-FET ($Q_{111}$) ist, bei dem seine zwei Gate-Anschlüsse mit seinem Source-Anschluß verbunden sind.

7. Eine FET-Schaltung nach Anspruch 1, bei der die genannten FETs Schottky - Sperrschicht - Gate - FETs sind.

8. Eine FET-Schaltung nach Anspruch 1, bei der jeder Inverter den genannten Eingangsstufen - FET ($Q_{51}$, $Q_{52}$) und einen weiteren FET ($Q_{53}$, $Q_{54}$) aufweist, der mit seinem Gate-Anschluß mit dem Drain-Anschluß des entsprechenden Eingangsstufen - FETs ($Q_{51}$, $Q_{52}$), mit seinem Source-Anschluß durch wenigstens eine zugeordnete Diode ($D_{51}$, $D_{52}$) mit einem entsprechenden Ausgangsanschluß (53, 54) und mit seinem Drain-Anschluß mit dem ersten Stromversorgungsanschluß (51) verbunden ist, und bei dem die Gate - Elektroden der Eingangsstufen - FETs ($Q_{51}$, $Q_{52}$) durch entsprechende Widerstände ($R_{53}$, $R_{54}$) mit einem anderen Stromversorgungsanschluß (55) verbunden sind.

9. Eine FET-Schaltung nach Anspruch 8, bei der die genannten zweiten und anderen Stromversorgungsanschlüsse (52, 55) gemeinsam sind.

10. Eine FET-Schaltung nach einem der Ansprüche 8 oder 9, bei der die anderen FETs ($Q_{53}$, $Q_{54}$) von dem normalerweise eingeschalteten Typ sind.

11. Eine FET-Schaltung, enthaltend ein erstes Rücksetz - Flip - Flop (91) und ein zweites Rücksetz - Flip - Flop (92) aufweist, die eine kombinierte Schaltung bilden, in der das genannte erste Rücksetz - Flip - Flop (91) und das genannte zweite Flip-Flop (92) in einer solchen Weise miteinander verbunden sind, daß die Ausgangsanschlüsse Q und $\overline{Q}$ des ersteren (91) mit den Eingangsanschlüssen S und R des letzteren (92) respective, ein Takt - Eingangsanschluß C des ersteren (91) und ein Referenz - Eingangsanschluß REF des letzteren (92) gemeinsam mit dem Takt - Eingangsanschluß (93) der kombinierten Schaltung, ein Referenz - Einganganschluß REF des ersteren (91) und ein Takt-Eingangsanschluß C des letzteren (92) gemeinsam mit einem ersten Referenz - Eingangsanschluß (94) der kombinierten Schaltung, ein Rücksetz - Eingangsanschluß R des ersteren (91) mit einem zweiten Referenz - Eingangsanschluß (96), ein Setz - Eingangsanschluß S des ersteren (91) mit einem Verzögerungs - Eingangsanschluß (95) der kombinierten Schaltung, Ausgangsanschlüsse Q und $\overline{Q}$ des letzteren (92) mit den Ausgangsanschlüssen (97 und 98) der kombinierten Schaltung respektive verbunden sind, wobei jedes der genannten Rücksetz - Flip - Flops (91, 92) eine FET-Schaltung nach Anspruch 1 aufweist.

**Revendications**

1. Circuit de transistors à effet de champ comprenant une paire d'inverseurs ($Q_{51}+Q_{53}$, $Q_{52}+Q_{54}$), chaque inverseur comportant un transistor à effet de champ d'étage d'entrée ($Q_{51}$, $Q_{52}$), dans lequel les transistors à effet de champ de l'étage d'entrée sont connectés par leurs sources à un point de connexion commun (C) par leurs drains per l'intermédiaire de résistances respectives ($R_{51}$, $R_{52}$) à une première borne d'alimentation et par leurs électrodes de grille aux bornes de sortie (53, 54) de l'autre inverseur respectif ($Q_{52}+Q_{54}$, $Q_{51}+Q_{53}$) caractérisé en ce que:

—un moyen de source de courant ($R_{55}$) est connecté entre le point de connexion commun (C) et une seconde borne d'alimentation (52).

2. Circuit de transistors à effet de champ selon la revendication 1, dans lequel la seconde borne d'alimentation (52) est une borne de mise à la masse.

3. Circuit de transistors à effet de champ selon la revendication 1, dans lequel le moyen de source de courant est une résistance ($R_{55}$).

4. Circuit de transistors à effet de champ selon la revendication 1, dans lequel le moyen de source de courant est un circuit source-drain d'un autre transistor à effet de champ ($Q_{111}$).

5. Circuit de transistors à effet de champ selon la revendication 4, dans lequel la grille de l'autre transistor à effet de champ ($Q_{111}$) est connectée à sa source.

6. Circuit de transistors à effet de champ selon la revendication 5, dans lequel le moyen de source de courant est un transistor à effet de champ à grille double ($Q_{111'}$) avec ses deux grilles connectées à sa source.

7. Circuit de transistors à effet de champ selon la revendication 1, dans lequel les transistors à effet de champ sont des transistors à effet de champ à jonction Schottky.

8. Circuit de transistors à effet de champ selon la revendication 1, dans lequel chaque inverseur comprend le transistor à effet de champ d'étage d'entrée ($Q_{51}$, $Q_{52}$) et un autre transistor à effet de champ ($Q_{53}$, $Q_{54}$), qui est connecté par sa grille au drain du transistor à effet de champ correspondant ($Q_{51}$, $Q_{52}$) de l'étage d'entrée, par sa source par l'intermédiaire d'au moins une diode respective (D51, D52), à une borne respective de sortie (53, 54) et par son drain à la première borne d'alimentation (51), et dans lequel les électrodes de grille des transistors à effet de champ de l'étage d'entrée ($Q_{51}$, $Q_{52}$) sont connectées par l'intermédiaire de résistances respectives ($R_{53}$, $R_{54}$) à une autre borne d'alimentation (55).

9. Circuit de transistors à effet de champ selon la revendication 8, dans lequel la seconde borne et l'autre borne d'alimentation (52, 55) sont communes.

10. Circuit de transistors à effet de champ selon l'une quelconque des revendications 8 ou 9, dans lequel les autres transistors à effet de champ ($Q_{53}$, $Q_{54}$) sont du type normalement conducteur.

11. Circuit de transistors à effet de champ comprenant une première bascule de remise à zéro-charge (91) et une seconde bascule de remise à zéro-charge (92), qui forment un circuit composite, dans lequel la première bascule de remise à zéro-charge (91) et la seconde bascule (92) sont connectées d'une manière telle que les bornes de sortie Q et $\overline{Q}$ de la première (91) sont connectées aux bornes d'entrée S et R de la seconde (92), respectivement, une borne d'entrée d'horloge C de la première (91) et une borne d'entrée de référence REF de la seconde (92) sont connectée en commun à une borne d'entrée d'horloge (93) du circuit composite, une borne d'entrée de référence REF de la première (91) et une borne d'entrée d'horloge C de la seconde (92) sont connectées en commun à une première borne d'entrée de référence (94) du circuit composite, une borne d'entrée de remise à zéro R de la première (91) est connectée à une seconde borne d'entrée de référence (96), une borne d'entrée de charge S de la première (96) est connectée à une borne d'entrée de retard (95) du circuit composite, les bornes de sortie Q et $\overline{Q}$ de la seconde (92) sont connectées aux bornes de sortie (97 et 98) du circuit composite, respectivement, dans lequel chacune des bascules de remise à zéro-charge (91, 92) comprend un circuit de transistor à effet de champ selon la revendication 1.

FIG.1 (Prior Art)

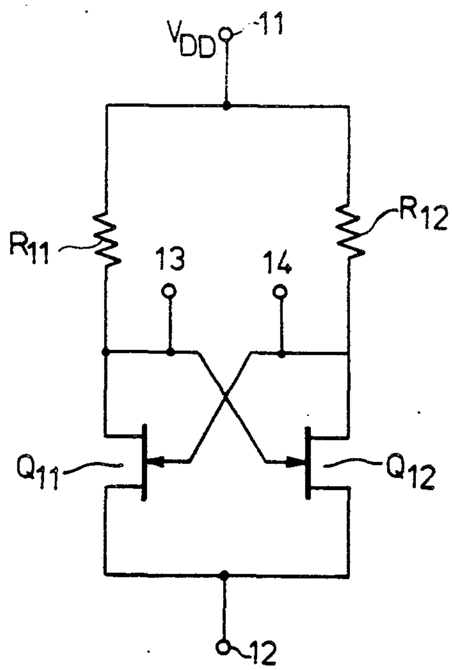


FIG.2 (Prior Art)

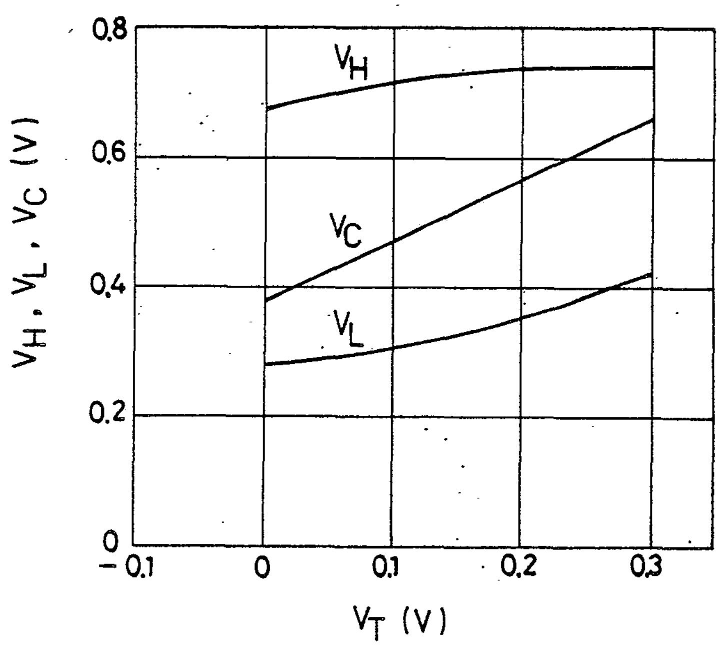

FIG.3 (Prior Art)

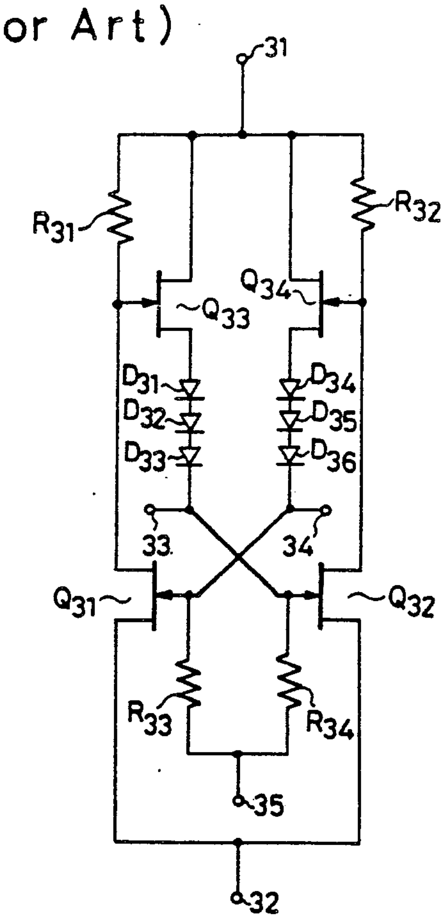


FIG.4 (Prior Art)

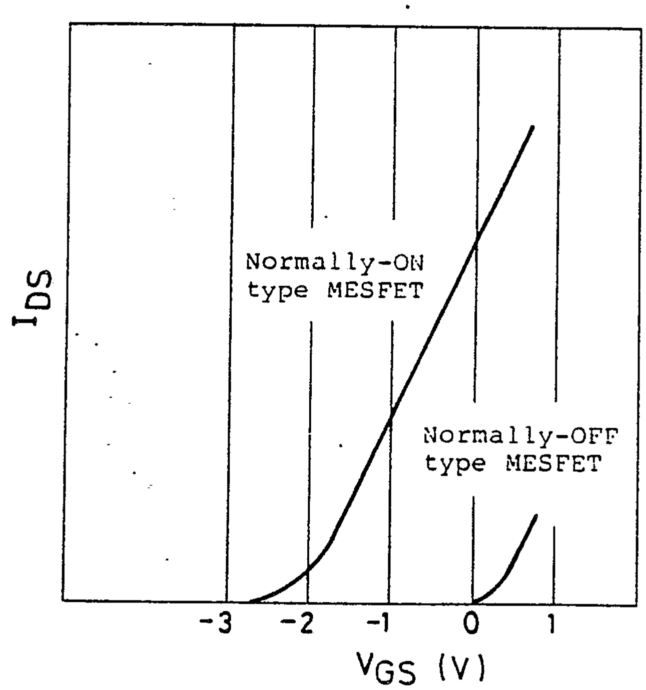

F I G. 5

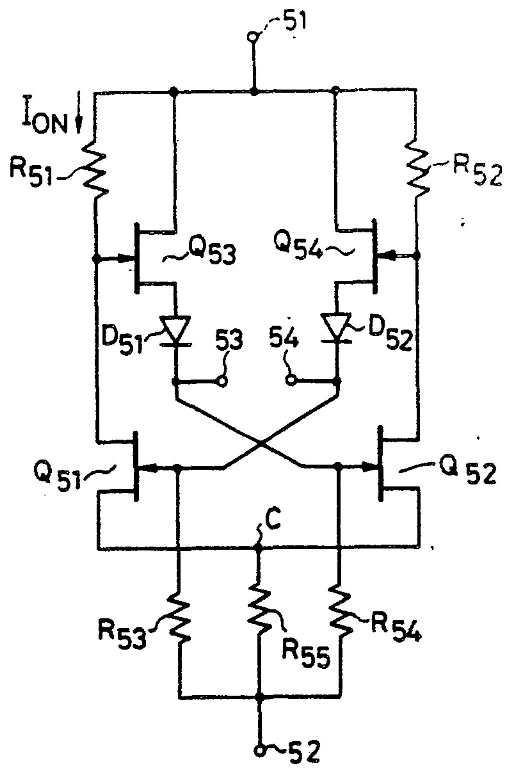
51
$I_{ON}$
$R_{51}$
$R_{52}$
$Q_{53}$
$Q_{54}$
$D_{51}$
53
54
$D_{52}$
$Q_{51}$
$Q_{52}$
C
$R_{53}$
$R_{55}$
$R_{54}$
52

F I G. 6

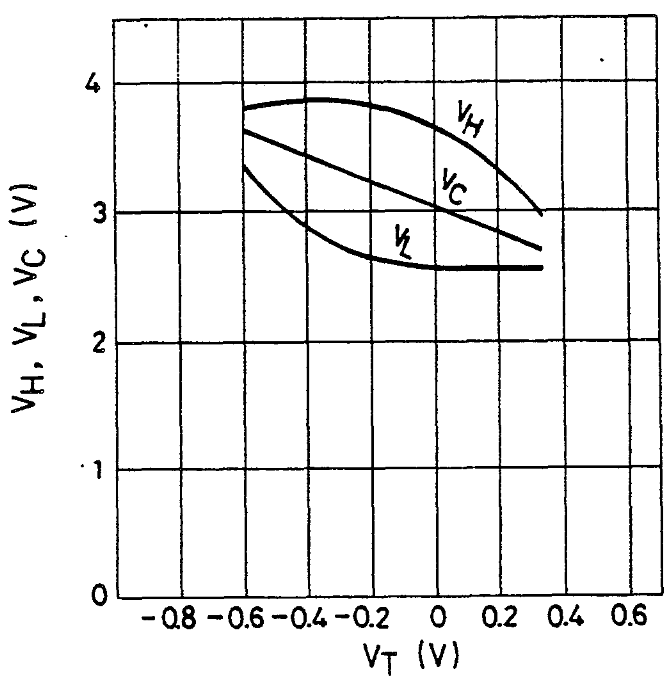
$V_H$, $V_L$, $V_C$ (V)
4
3
2
1
0
$V_H$
$V_C$
$V_L$
−0.8 −0.6 −0.4 −0.2 0 0.2 0.4 0.6
$V_T$ (V)

FIG.7

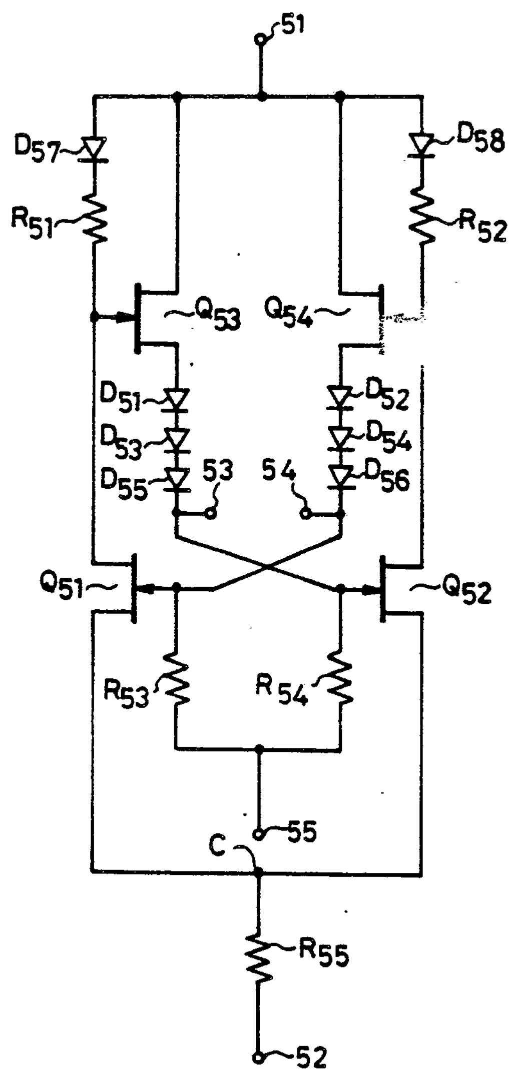
51
D57
D58
R51
R52
Q53
Q54
D51
D52
D53
D54
D55
D56
53
54
Q51
Q52
R53
R54
55
C
R55
52

FIG. 8

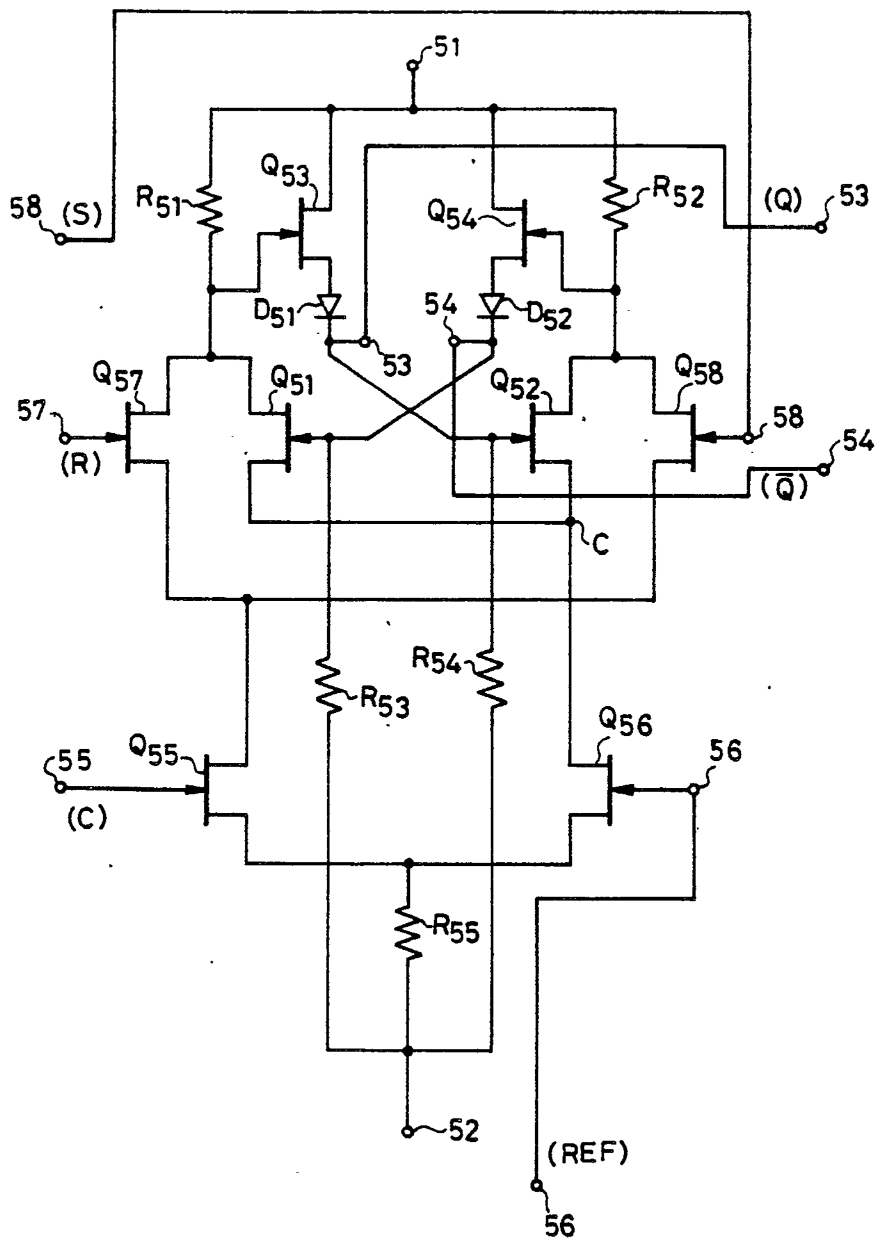
51
58 (S)
R51
Q53
Q54
R52
(Q) 53
D51
54
D52
53
Q57
Q51
Q52
Q58
57
(R)
58
54
(Q̄)
C
R54
R53
Q56
Q55
55
(C)
56
R55
52
(REF)
56

FIG.9

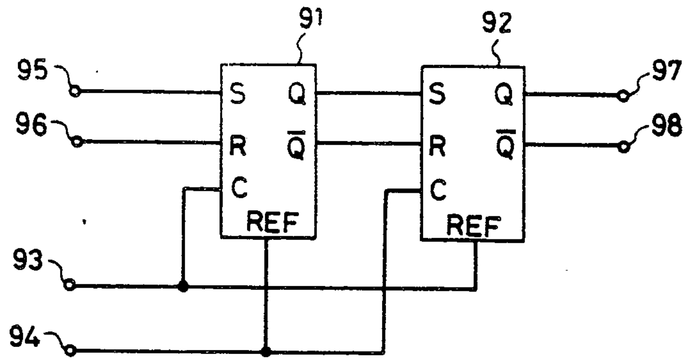
91
92
95
96
93
94
97
98
S
R
C
Q
$\overline{Q}$
REF
S
R
C
Q
$\overline{Q}$
REF

FIG.10

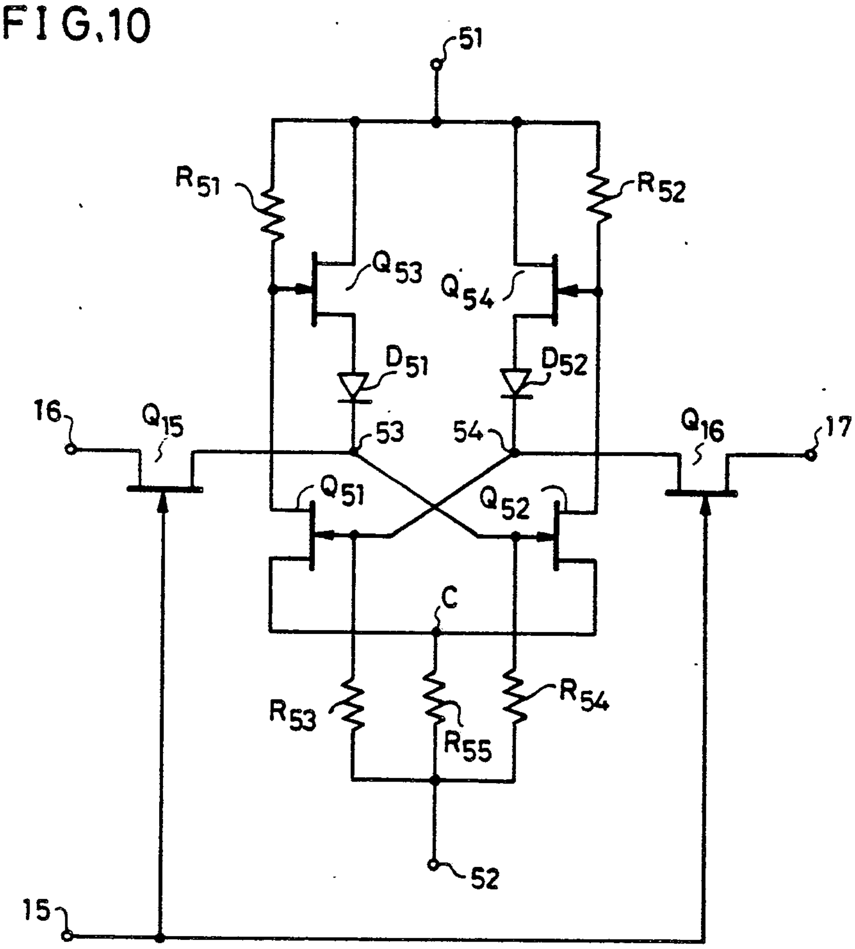
51
R51
R52
Q53
Q54
D51
D52
16
Q15
53
54
Q16
17
Q51
Q52
C
R53
R55
R54
52
15

FIG.11 (a)

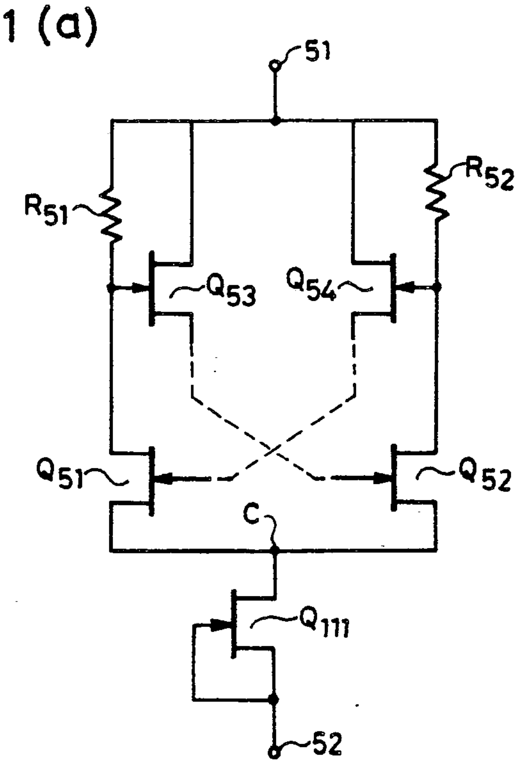


FIG.11(b)

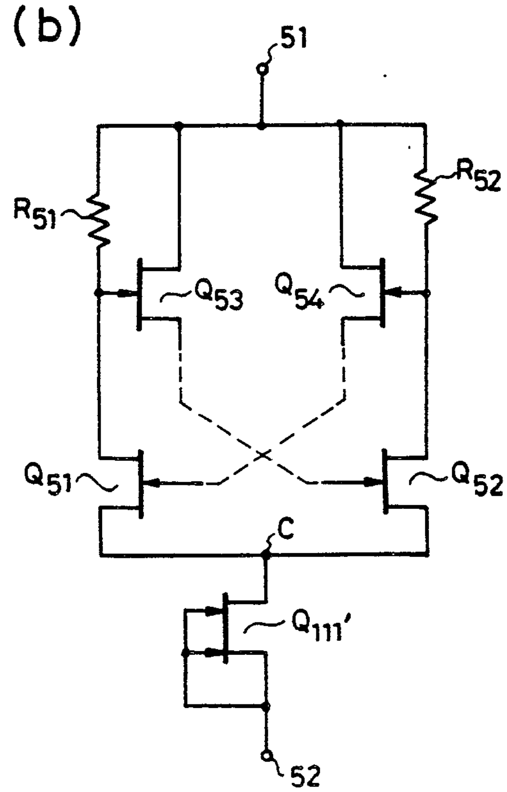

FIG.12